(19) Europäisches Patentamt
European Patent Office
Office européen des brevets

(11) EP 4 209 284 A1

(12) EUROPEAN PATENT APPLICATION
published in accordance with Art. 153(4) EPC

(43) Date of publication:
**12.07.2023 Bulletin 2023/28**

(21) Application number: **21864434.2**

(22) Date of filing: **03.09.2021**

(51) International Patent Classification (IPC):
***B08B 3/08*** *(2006.01)* ***C11D 7/34*** *(2006.01)*
***C11D 7/50*** *(2006.01)* ***H05K 3/34*** *(2006.01)*

(52) Cooperative Patent Classification (CPC):
**B08B 3/08; C11D 7/04; C11D 7/22; C11D 7/34; C11D 7/50; C23G 1/18; C23G 1/20; H01L 21/304; H05K 3/34**

(86) International application number:
**PCT/JP2021/032460**

(87) International publication number:
**WO 2022/050382 (10.03.2022 Gazette 2022/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **04.09.2020 JP 2020149279**

(71) Applicant: **Kao Corporation**
**Chuo-ku**
**Tokyo 103-8210 (JP)**

(72) Inventors:
- **SHIBA, Hiroya**
**Wakayama-shi, Wakayama 640-8580 (JP)**
- **TERUYA, Yuta**
**Wakayama-shi, Wakayama 640-8580 (JP)**
- **TAKADA, Shingo**
**Wakayama-shi, Wakayama 640-8580 (JP)**

(74) Representative: **Hoffmann Eitle**
**Patent- und Rechtsanwälte PartmbB**
**Arabellastraße 30**
**81925 München (DE)**

# (54) FLUX CLEANING AGENT COMPOSITION

(57) An aspect of the present disclosure provides a flux cleaning composition excellent in removing both of fluxes and metal discoloration caused by a heat treatment at 200°C or higher.

An aspect of the present disclosure relates to a flux cleaning composition containing an alkali agent (component A), a reducing compound having a mercapto group (component B), an organic solvent (component C), and water (component D), and the flux cleaning composition has a pH of 6 or more and 10 or less.

EP 4 209 284 A1

## Description

### Technical Field

The present disclosure relates to a flux cleaning composition and a cleaning method using the cleaning composition.

### Background Art

Metals such as copper and copper alloys are used as electrodes constituting circuits of electronic substrates of semiconductor packages, etc., to reduce production costs.

Surface-mount technology, which provides a high mounting density, has been widely adopted as one of mounting methods of printed-wiring boards. For achieving such a high mounting density, a technique has been known that includes applying a nanometal paste between terminals of substrate wiring and electronic elements, and heat-melting and solidifying the nanometal to connect terminals of substrate wiring and electronic elements.

For example, JP 2020-035721 A (Patent Document 1) discloses a semiconductor device that is bonded and fixed to a substrate with use of a die attachment material including a paste composition. The paste composition contains specific silver fine particles, specific silver powder, a silicon-containing triazine compound, and a carboxylic acid compound (acid anhydride) having a boiling point of 100°C to 300°C as a sintering aid. Patent Document 1 also discloses that a carboxylic acid compound having a boiling point higher than 300°C is unfavorable because flux components (organic substances such as an organic acid) remain in a film without being volatilized during sintering.

A technique has been also known for cleaning solder fluxes remaining on electronic components after soldering. For example, International Publication No. 2005/021700 (Patent Document 2) discloses a cleaning agent for removing solder fluxes, containing benzyl alcohol, amino alcohol, and a glycol compound, characterized in that when the content of the glycol compound is less than 1% by weight relative to the total amount of the cleaning agent, the content of the benzyl alcohol is 70 to 99.9% by weight, and the content of the amino alcohol is 0.1 to 30% by weight, and when the content of the glycol compound is 1 to 40% by weight, the content of the benzyl alcohol is 15 to 99% by weight and the content of the amino alcohol is 0.1 to 30% by weight.

JP 2015-216276 A (Patent Document 3) discloses a method for producing a circuit board with solidified solder, including cleaning flux residues on a circuit board generated in a process of solidifying solder on an electrode, with use of a cleaning agent containing glycol ether, alkanolamine, and a specific imidazole compound.

### Disclosure of Invention

An aspect of the present disclosure relates to a flux cleaning composition, containing an alkali agent (component A), a reducing compound having a mercapto group (component B), an organic solvent (component C), and water (component D), and the flux cleaning composition has a pH of 6 or more and 10 or less.

An aspect of the present disclosure relates to a cleaning method, including a cleaning process of cleaning an object with a flux, with use of the flux cleaning composition of the present disclosure. The object with a flux is a substrate onto which a flux-containing slurry has been applied between the substrate and a metal member or between two metal members on the substrate and thereafter that has undergone a process of heating to 200°C or higher.

An aspect of the present disclosure relates to use of the flux cleaning composition of the present disclosure for removing metal discoloration and a flux.

An aspect of the present disclosure relates to use of the flux cleaning composition of the present disclosure for cleaning a substrate onto which a flux-containing slurry has been applied between the substrate and a metal member or between two metal members on the substrate and thereafter that has undergone a process of heating to 200°C or higher.

### Description of the Invention

To connect terminals of substrate wiring and electronic elements by applying a nanometal paste containing an acid (flux component) and heat-melting and solidifying the nanometal, it is necessary to perform a process of maintaining the substrate at a high temperature of 200°C or higher to solidify the metal. If the acid-base flux remains on the substrate having undergone the process, the flux needs to be cleaned. The cleaning agents for removing solder fluxes of Patent Documents 2 and 3 do not provide satisfactory detergency against fluxes (flux removability) derived from acid having undergone the process of maintaining the substrate at a high temperature of 200°C or higher.

The surface may be oxidized and discolored when maintained at a high temperature of 200°C or higher, depending on the type of the metal of the substrate surface and the metal member. Therefore, cleaning compositions are demanded to be capable of removing portions discolored by the heat treatment at 200°C or higher, i.e., oxidized

metal (metal oxide).

In view of the above, the present disclosure provides a flux cleaning composition that is excellent in removing both of fluxes and metal discoloration caused by the heat treatment at 200°C or higher.

The present inventors have accomplished the present disclosure based on the finding that a reducing compound having a mercapto group can enhance the removability of both of fluxes and metal discoloration caused by the heat treatment at 200°C or higher.

An aspect of the present disclosure relates to a flux cleaning composition (hereinafter, also referred to as a "cleaning composition of the present disclosure") containing an alkali agent (component A), a reducing compound having a mercapto group (component B), an organic solvent (component C), and water (component D), wherein the flux cleaning composition has a pH of 6 or more and 10 or less.

The present disclosure provides a flux cleaning composition that is excellent in removing both of fluxes and metal discoloration caused by the heat treatment at 200°C or higher.

A detailed action mechanism of expressing the effects of the present disclosure is unclear, but the following is considered.

At a specific pH, the reducing compound adsorbs on the metal surface (the substrate surface and/or the metal member) and causes a reduction reaction, changing the condition of the discolored metal surface and removing the discoloration from the metal surface. It is also considered that the organic solvent enhances the penetration of the flux cleaning composition into fluxes and causes interfacial debonding between metal and fluxes. Thus, the flux cleaning composition exhibits high detergency in addition to easy dissolubility by alkali agents and dissolution by solvents generally adopted.

The present disclosure, however, is not limited to this mechanism.

The "flux" in the present disclosure in one or more embodiments refers to a flux for joining two members through a sintering process (e.g., a process of maintaining an object at a high temperature of 200°C or higher) and is used for joining a heat sink and a semiconductor device or joining a heat sink and a substrate, for example. The flux in one or more embodiments is an acid-based joining aid.

The "flux cleaning composition" in one or more embodiments of the present disclosure refers to a cleaning composition for removing fluxes remaining after joining two members through the sintering process.

[Component A: Alkali Agent]

The cleaning composition of the present disclosure includes an alkali agent (hereinafter, also referred to as a "component A" simply). The component Ain one or more embodiments may be at least one selected from inorganic alkalis and organic alkalis. The component A may be one kind or a combination of two or more kinds.

Examples of the inorganic alkalis include ammonia and alkali metal hydroxides. Examples of the alkali metal hydroxides include sodium hydroxide and potassium hydroxide. Among these, at least one selected from ammonia and sodium hydroxide is preferred from the viewpoint of enhancing the removability of both of metal discoloration and fluxes.

Examples of the organic alkalis in one or more embodiments include quaternary ammonium hydroxides represented by Formula (I) below, amines represented by Formula (II) below, and alkylimidazoles.

[Chemical Formula 1]

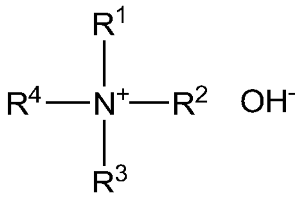

(I)

In Formula (I) above, $R^1$, $R^2$, $R^3$, and $R^4$ are each independently at least one selected from a methyl group, an ethyl group, a propyl group, a hydroxymethyl group, a hydroxyethyl group, and a hydroxypropyl group.

The quaternary ammonium hydroxide represented by Formula (I) is, for example, a salt of a quaternary ammonium cation and a hydroxide. The quaternary ammonium hydroxide may be at least one selected from tetramethylammonium hydroxide (TMAH), tetraethylammonium hydroxide, tetrapropylammonium hydroxide, 2-hydroxyethyltrimethylammonium hydroxide (choline), 2-hydroxyethyltriethylammonium hydroxide, 2-hydroxyethyltripropylammonium hydroxide, 2-hydroxypropyltrimethylammonium hydroxide, 2-hydroxypropyltriethylammonium hydroxide, 2-hydroxypropyltripropylammonium hydroxide, dimethylbis(2-hydroxyethyl)ammonium hydroxide, diethylbis(2-hydroxyethyl)ammonium

hydroxide, dipropylbis(2-hydroxyethyl)ammonium hydroxide, tris(2-hydroxyethyl)methylammonium hydroxide, tris(2-hydroxyethyl)ethylammonium hydroxide, tris(2-hydroxyethyl)propylammonium hydroxide, tetrakis(2-hydroxyethyl)ammonium hydroxide, and tetrakis(2-hydroxypropyl)ammonium hydroxide. Among these, tetramethylammonium hydroxide and tetraethylammonium hydroxide are preferred, and tetramethylammonium hydroxide (TMAH) is more preferred, from the viewpoint of enhancing the removability of both of metal discoloration and fluxes.

[Chemical Formula 2]

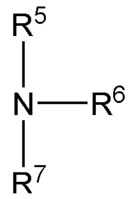

(II)

In Formula (II) above, $R^5$ is a hydrogen atom, a hydroxyl group, a hydrocarbon group having 1 to 6 carbon atoms, a hydroxyalkyl group having 1 to 6 carbon atoms, or an aminoalkyl group having 1 to 6 carbon atoms. $R^6$ and $R^7$ are the same or different from each other, and a hydrogen atom, a hydrocarbon group having 1 to 6 carbon atoms, a hydroxyalkyl group having 1 to 6 carbon atoms, or an aminoalkyl group having 1 to 6 carbon atoms. $R^5$, $R^6$, and $R^7$ are not simultaneously hydrogen atoms.

The amine represented by Formula (II) may be at least one selected from monoethanolamine, monoisopropanolamine, N-methylethanolamine, N-methylisopropanolamine, N-ethylethanolamine, N-ethylisopropanolamine, N-butylethanolamine, diethanolamine, diisopropanolamine, N,N-dimethylethanolamine, N,N-dibutylethanolamine, N,N-dimethylisopropanolamine, N-methyldiethanolamine, N-methyldiisopropanolamine, N,N-diethylethanolamine, N,N-diethylisopropanolamine, N-ethyldiethanolamine, N-ethyldiisopropanolamine, N-(β-aminoethyl)ethanolamine, N-(β-aminoethyl)isopropanolamine, N-(β-aminoethyl)diethanolamine, N-(β-aminoethyl)diisopropanolamine, ethylenediamine, and diethylenetriamine. Among these, monoethanolamine, N-methylethanolamine, N-butylethanolamine, and N,N-dibutylethanolamine are preferred from the viewpoint of enhancing the removability of both of metal discoloration and fluxes.

The alkylimidazole may be at least one selected from butylimidazole, propylimidazole, isopropylimidazole, ethylimidazole, methylimidazole, and 1,2-dimethylimidazole. Among these, at least one selected from methylimidazole, isopropylimidazole, and 1,2-dimethylimidazole are preferred from the viewpoint of enhancing the removability of both of metal discoloration and fluxes.

Among these, the component A may be at least one selected from sodium hydroxide, ammonia, monoethanolamine, methylethanolamine, butylethanolamine, dibutylethanolamine, tetramethylammonium hydroxide, and methylimidazole, from the viewpoint of enhancing the removability of both of metal discoloration and fluxes.

The content of the component A in the cleaning composition of the present disclosure at the time of use may adjusted so that the pH of the cleaning composition falls within a specific range.

[Component B: Reducing Compound having a Mercapto Group]

The cleaning composition of the present disclosure includes a reducing compound having a mercapto group (hereinafter, also referred to as a "component B" simply). The component B may be one kind or a combination of two or more kinds.

The component B in one or more embodiments may be a reducing compound having a mercapto group and a carboxyl group, or a reducing compound having a mercapto group and a hydroxyl group. Examples of the reducing compound having a mercapto group and a carboxyl group include thioglycolic acid or salts thereof, 3-mercaptopropionic acid, L-cysteine, and N-acetylcysteine. An example of the reducing compound having a mercapto group and a hydroxyl group is thioglycerol.

The molecular weight of the component B is preferably 40 or more, more preferably 60 or more, and further preferably 70 or more from the viewpoint of volatility, while the molecular weight thereof is more preferably 150 or less, further preferably 130 or less, and still further preferably 110 or less from the viewpoint of the penetration speed into fluxes.

The component B in one or more embodiments may be at least one selected from thioglycolic acid or salts thereof, 3-mercaptopropionic acid, thioglycerol, L-cysteine, and N-acetylcysteine, from the viewpoint of enhancing the removability of both of metal discoloration and fluxes. The component B in one or more embodiments is preferably thioglycerol from the viewpoint of preventing the corrosion of iron or alloys thereof (e.g., steel, stainless steel).

The content of the component B in the cleaning composition of the present disclosure at the time of use is preferably 0.5% by mass or more, more preferably 0.8% by mass or more, and further preferably 5% by mass or more

from the viewpoint of the removability of oxides, while the content thereof is preferably 25% by mass or less, more preferably 20% by mass or less, further preferably 15% by mass or less, and still further preferably 12% by mass or less from the viewpoint of preventing reoxidation. More specifically, the content of the component B in the cleaning composition of the present disclosure at the time of use is preferably 0.5% by mass or more and 25% by mass or less, more preferably 0.8% by mass or more and 20% by mass or less, and further preferably 5% by mass or more and 12% by mass or less. When the component B is a combination of two or more kinds, the content of the component B refers to the total content of the two or more kinds.

[Component C: Organic Solvent]

The cleaning composition of the present disclosure includes an organic solvent (hereinafter, also referred to as a "component C"). The component C in one or more embodiments is preferably at least one solvent selected from compounds represented by Formula (III) below, compounds represented by Formula (IV) below, compounds represented by Formula (V) below, alkyl sulfoxides, and α-olefins, from the viewpoint of enhancing the removability of both of metal discoloration and fluxes. The component C may be one kind or a combination of two or more kinds.

$$R^8\text{-O-(AO)}_n\text{-}R^9 \qquad \text{(III)}$$

In Formula (III) above, $R^8$ is preferably a phenyl group or an alkyl group having 1 to 8 carbon atoms, more preferably an alkyl group having 1 to 8 carbon atoms, and further preferably an alkyl group having 4 to 6 carbon atoms, from the viewpoint of enhancing the removability of both of metal discoloration and fluxes. $R^9$ is preferably a hydrogen atom or an alkyl group having 1 to 4 carbon atoms, and more preferably a hydrogen atom or an alkyl group having 2 to 4 carbon atoms from the same viewpoint. AO is an ethylene oxide group (EO) or a propylene oxide group (PO), and preferably an ethylene oxide group from the same viewpoint. Moreover, n is an addition molar number of AO, and preferably an integer of 1 to 3, more preferably 2 or 3, and further preferably 2 from the same viewpoint.

Examples of the compounds represented by Formula (III) above include the following: monophenyl ethers such as ethylene glycol monophenyl ether, diethylene glycol monophenyl ether, and triethylene glycol monophenyl ether; monoalkyl ethers such as ethylene glycol monoalkyl ether having an alkyl group having 1 to 8 carbon atoms, diethylene glycol monoalkyl ether, triethylene glycol monoalkyl ether, and tripropylene glycol monoalkyl ether; dialkyl ethers such as ethylene glycol dialkyl ether having an alkyl group having 1 to 8 carbon atoms and an alkyl group having 1 to 4 carbon atoms, diethylene glycol dialkyl ether, and triethylene glycol dialkyl ether; phenylalkyl ethers such as ethylene glycol phenylalkyl ether having a phenyl group and an alkyl group having 1 to 4 carbon atoms, diethylene glycol phenylalkyl ether, and triethylene glycol phenylalkyl ether. Among these, the compound represented by Formula (III) is preferably at least one selected from diethylene glycol monoalkyl ether, tripropylene glycol monoalkyl ether, and diethylene glycol dialkyl ether from the viewpoint of enhancing the removability of both of metal discoloration and fluxes. Specifically, the compound represented by Formula (III) may be at least one selected from diethylene glycol monobutyl ether (butyl diglycol), tripropylene glycol methyl ether, diethylene glycol 2-ethylhexyl ether (2-ethylhexyl diglycol), and diethylene glycol diethyl ether.

$$R^{10}\text{-}CH_2OH \qquad \text{(IV)}$$

In Formula (IV) above, $R^{10}$ is preferably a phenyl group, a benzyl group, a cyclohexyl group, a furyl group, a tetrahydrofuryl group, a furfuryl group, or a tetrahydrofurfuryl group, more preferably a phenyl group, a cyclohexyl group, or a tetrahydrofuryl group, and further preferably a phenyl group, from the viewpoint of enhancing the removability of both of metal discoloration and fluxes.

Examples of the compounds represented by Formula (IV) above include benzyl alcohol, phenethyl alcohol, cyclohexane methanol, furfuryl alcohol, and tetrahydrofurfuryl alcohol. Among these, benzyl alcohol is preferred from the viewpoint of enhancing the removability of both of metal discoloration and fluxes.

[Chemical Formula 3]

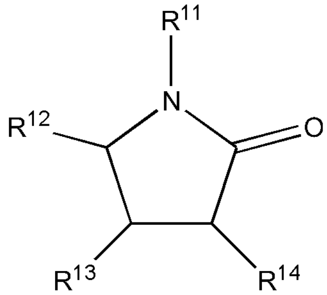

(V)

In Formula (V) above, preferably $R^{11}$, $R^{12}$, $R^{13}$, and $R^{14}$ are each independently a hydrogen atom, a hydrocarbon group having 1 to 8 carbon atoms, a hydroxyalkyl group having 1 to 3 carbon atoms or a hydroxyl group; and more preferably one of $R^{11}$, $R^{12}$, $R^{13}$, or $R^{14}$ is a hydrocarbon group having 1 to 8 carbon atoms, further preferably a hydrocarbon group having 1 to 6 carbon atoms, and still further preferably any of a methyl group, an ethyl group, or a vinyl group, from the viewpoint of enhancing the removability of both of metal discoloration and fluxes.

Examples of the compounds represented by Formula (V) above include 2-pyrrolidone, 1-methyl-2-pyrrolidone, 1-ethyl-2-pyrrolidone, 1-vinyl-2-pyrrolidone, 1-phenyl-2-pyrrolidone, 1 -cyclohexyl-2 -pyrrolidone, 1 -octyl-2 -pyrrolidone, 3-hydroxypropyl-2-pyrrolidone, 4-hydroxy-2-pyrrolidone, 4-phenyl-2-pyrrolidone, and 5-methyl-2-pyrrolidone. The compound represented by Formula (V) above is preferably at least one selected from 2-pyrrolidone, 1-methyl-2-pyrrolidone, 1-ethyl-2-pyrrolidone, 1-vinyl-2-pyrrolidone, 1-phenyl-2-pyrrolidone, 1-cyclohexyl-2-pyrrolidone, 1-octyl-2-pyrrolidone, and 5-methyl-2-pyrrolidone, more preferably at least one selected from 1-methyl-2-pyrrolidone, 1-ethyl-2-pyrrolidone, and 1-vinyl-2-pyrrolidon, and further preferably N-methyl-2-pyrrolidone, from the viewpoint of enhancing the removability of both of metal discoloration and fluxes.

An example of the alkyl sulfoxides is dimethyl sulfoxide (DMSO).

Examples of the $\alpha$-olefins include $\alpha$-olefins having 8 to 20 carbon atoms, and a specific example thereof is 1-dodecene.

The component C may be at least one selected from butyl diglycol, tripropylene glycol methyl ether, 2-ethylhexyl diglycol, benzyl alcohol, diethylene glycol diethyl ether, N-methyl-2-pyrrolidone (NMP), dimethyl sulfoxide (DMSO), and 1-dodecene, from the viewpoint of enhancing the removability of both of metal discoloration and fluxes.

The content of the component C in the cleaning composition of the present disclosure at the time of use is preferably 15% by mass or more, more preferably 20% by mass or more, further preferably 25% by mass or more, and still further preferably 45% by mass or more from the viewpoint of enhancing the removability of both of metal discoloration and fluxes, while it is preferably 85% by mass or less, more preferably 80% by mass or less, and further preferably 70% by mass or less from the same viewpoint. More specifically, the content of the component C in the cleaning composition of the present disclosure at the time of use is preferably 15% by mass or more and 80% by mass or less, more preferably 20% by mass or more and 80% by mass or less, and further preferably 45% by mass or more and 80% by mass or less. When the component C is a combination of two or more kinds, the content of the component C refers to the total content of the two or more kinds.

Amass ratio (B/C) of the component B to the component C in the cleaning composition of the present disclosure is preferably 0.001 or more, more preferably 0.01 or more, further preferably 0.1 or more, and still further preferably 0.3 or more from the viewpoint of reduction power, while the mass ratio (B/C) is preferably 2 or less, more preferably 1.5 or less, further preferably 1 or less, still further preferably 0.8 or less, and even further preferably 0.5 or less from the viewpoint of preventing reoxidation. More specifically, the mass ratio (B/C) is preferably 0.001 or more and 2 or less, more preferably 0.01 or more and 1.5 or less, further preferably 0.1 or more and 1 or less, and still further preferably 0.3 or more and 0.8 or less.

[Component D: Water]

The cleaning composition of the present disclosure includes water (hereinafter, also referred to as a "component D"). Examples of the water as the component D include ion-exchanged water, RO water (reverse osmosis membrane-treated water), distilled water, pure water, and ultrapure water.

The content of the component D in the cleaning composition of the present disclosure at the time of use is preferably 3% by mass or more, more preferably 4% by mass or more, further preferably 8% by mass or more, and still further preferably 10% by mass or more from the viewpoint of lowering the flash point and improving handleability, while it is preferably 75% by mass or less, more preferably 50% by mass or less, further preferably 40% by mass or less, still further preferably 30% by mass or less, and even further preferably 20% by mass or less from the viewpoint of the

detergency against fluxes. The content of the component D in the cleaning composition of the present disclosure in one or more embodiments is preferably 3% by mass or more and 40% by mass or less, more preferably 3% by mass or more and 30% by mass or less, and further preferably 3% by mass or more and 20% by mass or less. The content of the component D in the cleaning composition of the present disclosure in another one or a plurality of embodiments is preferably 4% by mass or more and 50% by mass or less.

[Other Components]

The cleaning composition of the present disclosure may contain other components that are generally used in detergents within a range that does not impair the effects of the present disclosure, and examples of the other components include a chelating agent, an anticorrosive agent such as benzotriazole (BTA), a thickener, a dispersant, a basic substance other than the component A, a polymer compound, a surfactant such as alkyl glucoside, a solubilizer such as caprylic acid, an antiseptic agent, a germicide, an antibacterial agent, an antifoaming agent, and an antioxidant. The content of the other components in the cleaning composition of the present disclosure at the time of use is preferably 0% by mass or more and 25% by mass or less, more preferably 0% by mass or more and 20% by mass or less, and further preferably 0% by mass or more and 15% by mass or less.

[Production Method of Cleaning Composition]

The cleaning composition of the present disclosure can be produced, for example, by blending the component A, the component B, the component C, the component D, and as appropriate the other components by a known method. The cleaning composition of the present disclosure in one or more embodiments may be composed of at least the component A, the component B, the component C, and the component D. An aspect of the present disclosure relates to a production method of the cleaning composition including a process of blending at least the component A, the component B, the component C, and the component D. In the present disclosure, "blending" includes mixing the component A, the component B, the component C, the component D, and as appropriate the other components simultaneously or in any order. The blending amount of each of the components in the production method of the cleaning composition of the present disclosure can the same as the content of each of the components in the cleaning composition of the present disclosure at the time of use. In the present disclosure, "the content of each of the components in the cleaning composition at the time of use" refers to the content of each of the components at the time of cleaning, i.e., at the time when the cleaning composition is started being used for cleaning.

[pH of Cleaning Composition]

The pH of the cleaning composition of the present disclosure is 6 or more and 10 or less. From the viewpoint of enhancing the removability of both of metal discoloration and fluxes, the pH is preferably 7 or more and 10 or less, and more preferably 7 or more and 9 or less. The pH can be appropriately adjusted using, for example, an inorganic acid such as nitric acid or sulfuric acid, an organic acid such as oxycarbonic acid, polycarboxylic acid, aminopolycarboxylic acid or amino acid, a metal salt or an ammonium salt thereof, or an alkali agent (component A). The pH of the cleaning composition in the present disclosure is a pH of the cleaning composition at 25°C at the time of use.

[Object to be Cleaned]

The cleaning composition of the present disclosure in one or more embodiments is used for cleaning an object with a flux.

The object with a flux in one or more embodiments is, for example, a substrate onto which a flux-containing slurry has been applied between the substrate and a metal member or between two metal members on the substrate and thereafter that has undergone a process of heating to 200°C or higher (heating process). Therefore, an aspect of the present disclosure relates to use of the flux cleaning composition of the present disclosure for cleaning a substrate onto which a flux-containing slurry has been applied between the substrate and a metal member or between two metal members on the substrate and thereafter that has undergone a process of heating to 200°C or higher (heating process).

In the heating process, the heating temperature may be, for example, 200°C to 350°C. The heating time may be, for example, 3 minutes to 5 hours. The object to be cleaned is preferably an object with a flux that has been heated for one hour or more, from the viewpoint of exhibiting the detergency against fluxes denatured by heat. In one or more embodiments, at least either of the substrate surface or the metal member of the object to be cleaned includes a portion where metal is discolored by heating, i.e., an oxidized portion (metal oxide).

The flux in one or more embodiments contains an acid as a main component. Examples of the acid include organic acids such as abietic acid.

The flux-containing slurry in one or more embodiments may further contain metal particles. The metal particles are preferably those having a sintering temperature (curing temperature) of 300°C or lower, and examples of such particles include particles of tin, copper, silver, and mixed metal thereof. The metal particles are preferably particles of copper, silver, or mixed metal thereof, and more preferably silver particles. The metal particles serve as a joining material that can join the substrate and the metal member or two metal members on the substrate. The flux-containing slurry in one or more embodiments may be used as a die attachment paste. If the flux-containing slurry further contains metal particles, the slurry in one or more embodiments may be used as a conductive die attachment paste.

The metal member in one or more embodiments is fixed on the substrate.

The metal member in one or more embodiments includes metal such as copper or iron as metal. Examples of the metal member include a heat sink and an electric circuit.

The substrate in one or more embodiments may be a substrate having a metal surface, and examples thereof include a copper substrate, a steel substrate, and a stainless steel substrate.

[Cleaning Method]

An aspect of the present disclosure relates to a cleaning method including a cleaning process of cleaning an object with a flux, with use of the cleaning composition of the present disclosure (hereinafter, also referred to as a "cleaning method of the present disclosure"). The object with a flux may be any of the objects to be cleaned described above. The cleaning process in one or more embodiments includes bringing the object with a flux into contact with the cleaning composition of the present disclosure. The cleaning method of the present disclosure enables efficient removal of both of fluxes and metal discoloration caused by the high-temperature treatment at 200°C or higher.

The cleaning process in one or more embodiments includes removing metal discoloration, with use of the flux cleaning composition of the present disclosure. Therefore, an aspect of the present disclosure relates to use of the flux cleaning composition of the present disclosure for removing metal discoloration and fluxes. The metal discoloration in one or more embodiments includes a portion where metal is oxidized by heating (metal oxide).

The method for cleaning the object with use of the cleaning composition of the present disclosure or the method for bringing the object into contact with the cleaning composition of the present disclosure may be performed, for example, by bringing the object into contact with the cleaning composition contained in a tank of an ultrasonic cleaning device or by spraying the cleaning composition onto the object (shower method). The cleaning composition of the present disclosure may be used without dilution.

The cleaning process in one or more embodiments is a process of immersing the object into the cleaning composition of the present disclosure. The immersion temperature is preferably 80°C or lower, more preferably 70°C or lower, further preferably 60°C or lower, and preferably 20°C or higher, more preferably 30°C or higher, and further preferably 40°C or higher, from the viewpoint of enhancing the removability of both of metal discoloration and fluxes. From the same viewpoint, the immersion time is preferably 5 minutes or more, more preferably 10 minutes or more, and further preferably 30 minutes or more, and preferably 3 hours or less, more preferably 2 hours or less, and further preferably 1 hour or less.

The cleaning method of the present disclosure preferably includes, after bringing the object into contact with the cleaning composition, rinsing the object with at least one of water or alcohol such as methanol and drying the object.

The cleaning method of the present disclosure preferably includes irradiating the object with ultrasonic waves at the time of bringing the object into contact with the cleaning composition of the present disclosure, and more preferably the ultrasonic waves are of a relatively strong, from the viewpoint of exerting the detergency of the cleaning composition of the present disclosure. The ultrasonic frequency is preferably 26 to 72 Hz and 80 to 1500 W, and more preferably 36 to 72 Hz and 80 to 1500 W from the same viewpoint.

[Kit]

An aspect of the present disclosure relates to a kit for use in the cleaning method of the present disclosure (hereinafter also referred to as a "kit of the present disclosure"). The kit of the present disclosure in one or more embodiments is a kit for producing the cleaning composition of the present disclosure.

The kit of the present disclosure in one or more embodiments is, for example, a kit (two-solution type cleaning composition) that includes a first solution containing the component A and a second solution containing the component B and the component C in a state in which the first solution and the second solution are not mixed together, and they are mixed before use. The first solution and the second solution may each contain the other components described above as appropriate. In one or more embodiments, the component D for preparing the cleaning composition of the present disclosure may be partially or entirely contained in at least one of the first solution or the second solution. A mixture of the first solution and the second solution in one or more embodiments may be diluted with water (component D) as appropriate.

Examples

Hereinafter, the present disclosure will be described in detail by way of examples. However, the following examples are not intended to limit the present disclosure.

1. Preparation of Cleaning Compositions (Examples 1 to 34 and Comparative Examples 1 to 7)

Cleaning compositions of Examples 1 to 34 and Comparative Examples 1 to 7 were prepared by blending components in a 100 mL glass beaker so that each of the components would have a composition indicated in Tables 1 to 5 below and mixing them under conditions below. The values of the components shown in Tables 1 to 5 represent the contents (mass%) of the components in the prepared cleaning compositions, unless otherwise specified. The pH of the cleaning compositions of Examples 1 to 32 and Comparative Examples 1 to 5 ranged from 7 to 9. The pH of the cleaning compositions of Examples 33 and 34 ranged from 7.2 to 7.6. The pH of the cleaning composition of Comparative Example 6 was 11.8, and the pH of the cleaning composition of Comparative Example 7 was 13.6. The pH indicated herein is a pH of the cleaning composition at 25°C measured using a pH meter (HM-30G manufactured by DKK-TOA CORPORATION) by dipping an electrode of the pH meter for three minutes in the cleaning composition.

<Mixing Conditions>

Liquid temperature: 25°C
Stirrer: magnetic stirrer (50 mm rotor)
Rotating speed: 300 rpm
Stirring time: 10 minutes

The following were used as the components of the cleaning compositions.

(Component A)

NaOH: Sodium hydroxide [manufactured by Nankai Chemical Co., Ltd.]
Ammonia [manufactured by FUJIFILM Wako Pure Chemical Corporation]
Monoethanolamine [manufactured by TOKYO CHEMICAL INDUSTRY CO., LTD.]
Methylethanolamine [manufactured by NIPPON NYUKAZAI CO., LTD.]
Butylethanolamine [manufactured by NIPPON NYUKAZAI CO., LTD.]
Dibutylethanolamine [manufactured by NIPPON NYUKAZAI CO., LTD.]
Triethanolamine [manufactured by NIPPON SHOKUBAI CO., LTD.]
Methyldiethanolamine [manufactured by NIPPON NYUKAZAI CO., LTD.]
Tetramethylammonium hydroxide [manufactured by TOKYO CHEMICAL INDUSTRY CO., LTD.]
N-Methylimidazole (methylimidazole) [manufactured by Kao Corporation]

(Component B)

Thioglycolic acid [manufactured by FUJIFILM Wako Pure Chemical Corporation, molecular weight: 92]
Ammonium thioglycolate [manufactured by FUJIFILM Wako Pure Chemical Corporation, molecular weight: 109]
3-Mercaptopropionic acid [manufactured by FUJIFILM Wako Pure Chemical Corporation, molecular weight: 106]
Thioglycerol [manufactured by TOKYO CHEMICAL INDUSTRY CO., LTD., molecular weight: 108]
L-Cysteine [manufactured by FUJIFILM Wako Pure Chemical Corporation, molecular weight: 121]
N-Acetylcysteine [manufactured by FUJIFILM Wako Pure Chemical Corporation, molecular weight: 163]

(Component C)

Butyl diglycol (BDG) [diethylene glycol monobutyl ether manufactured by NIPPON NYUKAZAI CO., LTD.]
Tripropylene glycol methyl ether [manufactured by FUJIFILM Wako Pure Chemical Corporation]
2-Ethylhexyl diglycol [manufactured by NIPPON NYUKAZAI CO., LTD.]
Benzyl alcohol [manufactured by LANXESS AG]
Diethylene glycol diethyl ether [manufactured by FUJIFILM Wako Pure Chemical Corporation]
NMP [N-methyl-2-pyrrolidone manufactured by FUJIFILM Wako Pure Chemical Corporation]

DMSO [dimethyl sulfoxide manufactured by FUJIFILM Wako Pure Chemical Corporation]
C12-α olefin [1-dodecene]
2-Methylimidazole [manufactured by SHIKOKU CHEMICALS CORPORATION]
p-Toluenesulfonic acid [manufactured by TOKYO CHEMICAL INDUSTRY CO., LTD.]

(Component D)

Water [pure water with 1 pS/cm or less produced by pure water apparatus G- 10DSTSET manufactured by ORGANO CORPORATION]
(Other Components)
Acrylic acid-maleic acid copolymer [POIZ manufactured by Kao Corporation]
Non-ionic surfactant [manufactured by Kao Corporation] (surfactant)
C7COOH [caprylic acid manufactured by Kao Corporation] (solubilizer)
Alkyl glucoside [manufactured by Kao Corporation] (surfactant)
Benzotriazole (BTA) [1,2,3-benzotriazole manufactured by TOKYO CHEMICAL INDUSTRY CO., LTD.] (anticorrosive agent)

2. Evaluation of Cleaning Compositions

The cleaning compositions of Examples 1 to 34 and Comparative Examples 1 to 7 were tested and evaluated for the detergency and the metal discoloration removability.

<Test Substrate>

Test substrates were each prepared by applying 0.05 g of abietic acid (flux) to a tough pitch copper substrate of 50 mm x 20 mm and heating the substrate for 3 hours at 300°C using a hot plate, with the abietic acid being partially present on the surface of the copper substrate.

Test substrates thus prepared were a model simulating the heating temperature and the holding time typically adopted for joining metals on substrates. For example, Patent Document 1 discloses, in examples, holding a temperature of 200°C for 60 minutes.

JP 2020-074498 A, which relates to a semiconductor device including a semiconductor element that is bonded with use of a nanoparticle bonding material, teaches that the nanoparticle bonding material can bind members at low temperatures of approximately 300°C or lower (paragraph [0025]), and when sintered silver is used as the nanoparticle bonding material, the sintering temperature, i.e., the curing temperature, is about 210°C.

[Evaluation of Detergency (Flux Removability)]

The test substrates were immersed into the cleaning compositions of 100 g at 25°C for one minute, taken out, rinsed with water, and dried with an air blower to prepare test substrates after cleaning. The flux removability was evaluated by visually observing the test substrates. The removal rate was calculated from an area where the appearance remained unchanged from the appearance before cleaning (area where flux still adhered) and an area to be cleaned. The removal rate was calculated from the following formula.

$$\text{Removal rate} = \text{Area where flux was removed by cleaning} / \text{Area where flux had adhered before cleaning} \times 100$$

[Metal Discoloration Removability]

Test substrates after cleaning were prepared in the same manner as in the evaluation of the detergency against fluxes except that abietic acid was not placed on the copper substrates. High-temperature treatments oxidize and blacken the surfaces of copper substrates. The metal discoloration removability was evaluated by visually observing the test substrates. The removal rate was calculated from an area where the appearance remained unchanged from the appearance before cleaning and an area to be cleaned. The discoloration removal rate was calculated from the following formula.

Discoloration removal rate = Area where metal discoloration was removed by cleaning / Area of metal discoloration before cleaning x 100

[Table 1]

| Table 1 | | Ex. 1 | Ex. 2 | Ex. 3 | Ex. 4 | Ex. 5 | Ex. 6 | Ex. 7 | Comp. Ex. 1 | Comp. Ex. 2 | Comp. Ex. 3 | Comp. Ex. 4 | Comp. Ex. 5 | Comp. Ex. 6 | Comp. Ex. 7 |
|---|---|---|---|---|---|---|---|---|---|---|---|---|---|---|---|
| Alkali (Component A) | NaOH | 5 | | | | | | | | | 5 | | | 12 | 16 |
| | Ammonia | | 5 | | | | | | | | | | | | |
| | Monoethanolamine | | | 8 | | | | | | | | | | | |
| | Methylethanolamine | | | | 8 | | | | | | | | | | |
| | Butylethanolamine | | | | | 15 | | | | | | | | | |
| | Dibutylethanolamine | | | | | | 20 | | | | | | | | |
| | Triethanolamine | | | | | | | | | | | 5 | | | |
| | Methyldiethanolamine | | | | | | | | | | | | 1 | | |
| | Tetramethylammonium hydroxide | | | | | | | 10 | | | 10 | | | | |
| Reducing agent (Component B) | Thioglycolic acid | 10 | 10 | 10 | 10 | 10 | 10 | 10 | | | | | | | |
| | Ammonium thioglycolate | | | | | | | | 4.5 | | 10 | | | | |
| | Thioglycerol | | | | | | | | | | | | | 10 | 10 |
| Solvent (Component C) | Butyl diglycol | 25 | 25 | 25 | 25 | 25 | 25 | 25 | 1 | 25 | | 25 | 87.5 | 25 | 25 |
| | Benzyl alcohol | 25 | 25 | 25 | 25 | 25 | 25 | 25 | | 25 | | 70 | | | |
| | 2-Methylimidazole | | | | | | | | | | | | 1 | | |
| | p-Toluenesulfonic acid | | | | | | | | | | | | 0.5 | | |
| Surfactant | Acrylic acid-maleic acid | | | | | | | | 3.7 | | | | | | |
| | Non-ionic surfactant | | | | | | | | 1 | | | | | | |
| Anticorrosive agent | BTA | 1 | 1 | 1 | 1 | 1 | 1 | 1 | | | | | | 1 | 1 |
| Water (Component D) | Water | 34 | 34 | 31 | 31 | 24 | 19 | 29 | 89.8 | 50 | 75 | | 10 | 52 | 48 |
| Discoloration removability | | 100 | 100 | 100 | 100 | 100 | 100 | 100 | 100 | 5 | 100 | 0 | 0 | 30 | 10 |

(continued)

| Table 1 | Ex. 1 | Ex. 2 | Ex. 3 | Ex. 4 | Ex. 5 | Ex. 6 | Ex. 7 | Comp. Ex. 1 | Comp. Ex. 2 | Comp. Ex. 3 | Comp. Ex. 4 | Comp. Ex. 5 | Comp. Ex. 6 | Comp. Ex. 7 |
|---|---|---|---|---|---|---|---|---|---|---|---|---|---|---|
| Flux removability | 80 | 85 | 80 | 75 | 75 | 80 | 80 | 5 | 55 | 5 | 5 | 5 | 60 | 60 |
| *Ex.: Example, Comp. Ex.: Comparative Example | | | | | | | | | | | | | | |

[Table 2]

| Table 2 | | Ex. 1 | Ex. 8 | Ex. 9 | Ex. 10 | Ex. 11 | Ex. 12 | Ex. 13 | Ex. 14 | Ex. 15 | Ex. 16 | Ex. 17 | Ex. 18 | Ex. 19 | Ex. 20 | Ex. 21 |
|---|---|---|---|---|---|---|---|---|---|---|---|---|---|---|---|---|
| Alkali (ComponentA) | NaOH | 5 | | | | | | | | | | | | | | |
| | Ammonia | | 5 | 5 | 5 | 5 | 5 | 5 | 5 | 5 | 5 | 5 | 5 | 5 | 5 | 5 |
| Reducing agent (Component B) | Thioglycolic acid | 10 | 10 | 10 | 10 | 10 | 10 | 10 | 10 | 10 | 10 | 10 | | | | |
| | 3-Mercaptopropionic acid | | | | | | | | | | | | 10 | | | |
| | Thioglycerol | | | | | | | | | | | | | 10 | | |
| | L-Cysteine | | | | | | | | | | | | | | 10 | |
| | N-Acetylcysteine | | | | | | | | | | | | | | | 10 |
| Solvent (Component C) | Butyl diglycol | 25 | 50 | | 25 | 25 | 25 | | 25 | 25 | 25 | | 25 | 25 | 25 | 25 |
| | Tripropylene glycol methyl ether | | | 50 | 25 | | | | | | | | | | | |
| | 2-Ethylhexyl diglycol | | | | | 25 | | | | | | | | | | |
| | Benzyl alcohol | 25 | | | | | 25 | | | | | | 25 | 25 | 25 | 25 |
| | Diethylene glycol diethyl ether | | | | | | | 50 | 25 | | | | | | | |
| | NMP | | | | | | | | | 25 | | 25 | | | | |
| | DMSO | | | | | | | | | | 25 | 25 | | | | |
| Anticorrosive agent | BTA | 1 | 1 | 1 | 1 | 1 | 1 | 1 | 1 | 1 | 1 | 1 | 1 | 1 | 1 | 1 |
| Water (Component D) | Water | 34 | 34 | 34 | 34 | 34 | 34 | 34 | 34 | 34 | 34 | 34 | 34 | 34 | 34 | 34 |
| Discoloration removability | | 100 | 100 | 100 | 100 | 100 | 100 | 100 | 100 | 100 | 100 | 100 | 75 | 100 | 100 | 40 |
| Flux removability | | 80 | 65 | 60 | 60 | 65 | 80 | 90 | 85 | 85 | 80 | 90 | 80 | 95 | 80 | 40 |
| * Ex.: Example | | | | | | | | | | | | | | | | |

[Table 3]

| Table 3 | | Ex. 1 | Ex. 22 | Ex. 23 | Ex. 24 | Ex. 25 | Ex. 26 | Ex. 27 | Ex. 28 | Ex. 29 | Ex. 30 | Ex. 31 | Ex. 32 |
|---|---|---|---|---|---|---|---|---|---|---|---|---|---|
| Alkali (ComponentA) | NaOH | 5 | | | | | | | | | | | |
| | Ammonia | | 5 | 5 | 5 | 5 | | | | | | | |
| | Monoethanolamine | | | 8 | 8 | 8 | | | 5 | 5 | 5 | 5 | 5 |
| | Methylethanolamine | | 8 | | | | | | | | | | |
| Reducing agent (Component B) | Thioglycolic acid | 10 | 10 | 10 | 10 | 10 | 1 | 20 | 10 | 10 | 10 | 10 | 10 |
| Solvent (Component C) | Butyl diglycol | 25 | | | | | 25 | 25 | 40 | 30 | 20 | 10 | 5 |
| | 2-Ethylhexyl diglycol | | | | 2.5 | | | | | | | | |
| | Benzyl alcohol | 25 | 30 | 30 | 10 | | 25 | 25 | 40 | 30 | 20 | 10 | 5 |
| | NMP | | | | | 25 | | | | | | | |
| | DMSO | | | | | 25 | | | | | | | |
| | C12-a olefin | | | | 5 | | | | | | | | |
| Solubilizer | C7COOH (caprylic acid) | | 15 | 15 | | | | | | | | | |
| Surfactant | Alkyl glucoside | | | | 20 | | | | | | | | |
| Anticorrosive agent | BTA | 1 | 1 | 1 | 1 | 1 | 1 | 1 | 1 | 1 | 1 | 1 | 1 |
| Water (Component D) | Water | 34 | 31 | 31 | 38.5 | 26 | 48 | 29 | 4 | 24 | 44 | 64 | 74 |
| Discoloration removability | | 100 | 100 | 100 | 100 | 100 | 80 | 100 | 100 | 100 | 100 | 100 | 100 |
| Flux removability | | 80 | 80 | 85 | 75 | 90 | 70 | 85 | 95 | 90 | 65 | 40 | 15 |
| * Ex.: Example | | | | | | | | | | | | | |

[Table 4]

| Table 4 | | Ex. 33 | Ex. 34 |
|---|---|---|---|
| Alkali (Component A) | Methylimidazole | 0.5 | 1 |
| Reducing agent (Component B) | Thioglycerol | 10 | 10 |
| Solvent (Component C) | Butyl diglycol | 10 | 10 |
| | Benzyl alcohol | 70 | 70 |
| Anticorrosive agent | BTA | 1 | 1 |
| Water (Component D) | Water | 8.5 | 8 |
| Discoloration removability | | 100 | 100 |
| Flux removability | | 90 | 90 |
| * Ex.: Example | | | |

Tables 1 to 4 indicate that the cleaning compositions of Examples 1 to 34 are excellent in removing both of metal discoloration and fluxes.

[Corrosiveness of Iron]

The corrosiveness of iron was evaluated, with use of the cleaning compositions of Example 19 and Example 12, assuming the corrosion of steel substrates and stainless steel substrates in cleaning tanks, rinsing tanks or the like of cleaning devices. Undiluted solutions and 5% aqueous solutions of the cleaning compositions of Examples 19 and Example 12 were also evaluated to simulate the use in the cleaning tank and that in the rinsing tank, respectively. The 5% aqueous solution of the cleaning composition assumes a case that the cleaning solution adhering to an object to be cleaned is mixed into a rinsing solution in the rinsing tank.

<Test Substrate>

Steel substrate: 50 mm x 20 mm SPCC steel substrate

Stainless steel substrate: 50 mm x 20 mm SUS304 steel substrate

<Evaluation Method>

The undiluted solutions and the 5% aqueous solutions of the cleaning compositions were prepared.
The test substrates were immersed into the solutions adjusted to room temperature.
The solutions one day and five days after immersion of the test substrates were collected to measure the eluted amount (unit: ppm) of iron in accordance with an ICP measurement.

[Table 5]

| Table 5 | | Ex. 19 | Ex. 12 |
|---|---|---|---|
| Alkali agent (Component A) | Ammonia | 5 | 5 |
| Reducing agent (Component B) | Thioglycolic acid | | 10 |
| | Thioglycerol | 10 | |
| Solvent (Component C) | Butyl diglycol | 25 | 25 |
| | Benzyl alcohol | 25 | 25 |
| Anticorrosive agent | BTA | 1 | 1 |
| Water (Component D) | Water | 34 | 34 |

(continued)

| Table 5 | | | | Ex. 19 | Ex. 12 |
|---|---|---|---|---|---|
| Discoloration removability | | | | 100 | 100 |
| Detergency against fluxes | | | | 95 | 80 |
| One-day immersion | Fe | SPCC | Eluted amount in undiluted solution | 237 | 715 |
| | | | Eluted amount in 5% aqueous solution | 8 | 35 |
| | Fe | SUS304 | Eluted amount in undiluted solution | 0 | 187 |
| | | | Eluted amount in 5% aqueous solution | 0 | 0 |
| Five-day immersion | Fe | SPCC | Eluted amount in undiluted solution | 642 | 1725 |
| | | | Eluted amount in 5% aqueous solution | 23 | 110 |
| | Fe | SUS304 | Eluted amount in undiluted solution | 15 | 625 |
| | | | Eluted amount in 5% aqueous solution | 0 | 0 |
| * Ex.: Example | | | | | |

Table 5 indicates that Example 19 using thioglycerol as the reducing agent (component B) retarded the corrosion of the steel substrate and the corrosion of the stainless steel substrate more effectively than Example 12 using thioglycolic acid as the reducing agent (component B).

Industrial Applicability

The cleaning composition of the present disclosure efficiently removes both of metal discoloration and fluxes, and thus shortening the flux cleaning process in the production of semiconductor devices and improving the performance and the reliability of semiconductor devices to be produced, and consequently increasing the productivity of semiconductor devices.

## Claims

1. A flux cleaning composition, comprising:

   an alkali agent (component A);
   a reducing compound having a mercapto group (component B);
   an organic solvent (component C); and
   water (component D),
   wherein the flux cleaning composition has a pH of 6 or more and 10 or less.

2. The flux cleaning composition according to claim 1, wherein the component B has a molecular weight of 150 or less.

3. The flux cleaning composition according to claim 1 or 2, wherein the flux cleaning composition comprises the component B in an amount of 0.5% by mass or more and 25% by mass or less.

4. The flux cleaning composition according to any of claims 1 to 3, wherein the flux cleaning composition comprises the component D in an amount of 4% by mass or more and 50% by mass or less.

5. A cleaning method, comprising a cleaning process of cleaning an object with a flux, with use of a flux cleaning composition,

   wherein the flux cleaning composition comprises an alkali agent (component A), a reducing compound having a mercapto group (component B), an organic solvent (component C), and water (component D),
   the flux cleaning composition has a pH of 6 or more and 10 or less, and
   the object with a flux is a substrate onto which a flux-containing slurry has been applied between the substrate

and a metal member or between two metal members on the substrate and thereafter that has undergone a process of heating to 200°C or higher.

**6.** The cleaning method according to claim 5, wherein the component B has a molecular weight of 150 or less.

**7.** The cleaning method according to claim 5 or 6, wherein the flux cleaning composition comprises the component B in an amount of 0.5% by mass or more and 25% by mass or less.

**8.** The cleaning method according to any of claims 5 to 7, wherein the flux cleaning composition comprises the component D in an amount of 4% by mass or more and 50% by mass or less.

**9.** The cleaning method according to any of claims 5 to 8, wherein the component B is a reducing compound having a mercapto group and a carboxyl group, or a reducing compound having a mercapto group and a hydroxyl group.

**10.** The cleaning method according to any of claims 5 to 9, wherein the cleaning process comprises removing metal discoloration, with use of the flux cleaning composition.

**11.** The cleaning method according to any of claims 5 to 10, wherein metal of the metal member comprises copper.

**12.** The cleaning method according to any of claims 5 to 11, wherein at least either of a substrate surface or the metal member of the object comprises a portion where metal is oxidized by heating.

**13.** The cleaning method according to any of claims 5 to 12, wherein the cleaning process comprises immersing the object into the flux cleaning composition at 80°C or lower.

**14.** The cleaning method according to any of claims 5 to 13, wherein the flux-containing slurry further comprises metal particles.

**15.** Use of the flux cleaning composition according to any of claims 1 to 4 for removing metal discoloration and a flux.

**16.** Use of the flux cleaning composition according to any of claims 1 to 4 for cleaning a substrate onto which a flux-containing slurry has been applied between the substrate and a metal member or between two metal members on the substrate and thereafter that has undergone a process of heating to 200°C or higher.

## INTERNATIONAL SEARCH REPORT

International application No.
**PCT/JP2021/032460**

**A. CLASSIFICATION OF SUBJECT MATTER**

***B08B 3/08***(2006.01)i; ***C11D 7/34***(2006.01)i; ***C11D 7/50***(2006.01)i; ***H05K 3/34***(2006.01)i
FI: C11D7/34; C11D7/50; H05K3/34 503Z; B08B3/08 Z

According to International Patent Classification (IPC) or to both national classification and IPC

**B. FIELDS SEARCHED**

Minimum documentation searched (classification system followed by classification symbols)

B08B3/08; C11D7/34; C11D7/50; H05K3/34

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2002-12896 A (MATSUSHITA ELECTRIC INDUSTRIAL CO., LTD.) 15 January 2002 (2002-01-15)<br>claims 6, 12, paragraphs [0039]-[0046], production examples 3, 4 | 1-16 |
| A | JP 2018-177974 A (JSR CORP.) 15 November 2018 (2018-11-15)<br>entire text | 1-16 |
| A | JP 2017-119782 A (KAO CORP.) 06 July 2017 (2017-07-06)<br>entire text | 1-16 |
| A | WO 2005/021700 A1 (KAKEN TECH CO., LTD.) 10 March 2005 (2005-03-10)<br>entire text | 1-16 |
| P, A | KR 10-2020-0106771 A (EXTOL CO., LTD.) 15 September 2020 (2020-09-15)<br>entire text | 1-16 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **27 October 2021** | **16 November 2021** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2021/032460**

| Patent document cited in search report | Publication date (day/month/year) | Patent family member(s) | Publication date (day/month/year) |
|---|---|---|---|
| JP 2002-12896 A | 15 January 2002 | (Family: none) | |
| JP 2018-177974 A | 15 November 2018 | CN 108728253 A<br>entire text<br>KR 10-2018-0115613 A<br>TW 201843298 A | |
| JP 2017-119782 A | 06 July 2017 | (Family: none) | |
| WO 2005/021700 A1 | 10 March 2005 | US 2006/0223732 A1<br>entire text<br>US 2008/0305979 A1<br>TW 200508385 A<br>KR 10-2006-0026029 A<br>KR 10-2007-0020144 A<br>CN 1798826 A<br>CN 101037646 A | |
| KR 10-2020-0106771 A | 15 September 2020 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020035721 A
- JP 2005021700 A
- JP 2015216276 A
- JP 2020074498 A